(19) Europäisches Patentamt
European Patent Office
Office européen des brevets

(11) **EP 4 772 889 A1**

(12) **EUROPEAN PATENT APPLICATION**
published in accordance with Art. 153(4) EPC

(43) Date of publication:
**08.07.2026  Bulletin 2026/28**

(21) Application number: **24936167.6**

(22) Date of filing: **01.11.2024**

(51) International Patent Classification (IPC):
*G01R 27/02* (2006.01)    *G01R 19/165* (2006.01)
*G01R 19/02* (2006.01)    *G01R 23/16* (2006.01)
*G01N 27/02* (2006.01)    *H01M 10/42* (2006.01)

(52) Cooperative Patent Classification (CPC):
**G01N 27/02; G01R 19/02; G01R 19/165;**
**G01R 23/16; G01R 27/02; H01M 10/42;** Y02E 60/10

(86) International application number:
**PCT/KR2024/017059**

(87) International publication number:
**WO 2025/220821 (23.10.2025 Gazette 2025/43)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **19.04.2024  KR 20240052763**

(71) Applicant: **LG Energy Solution, Ltd.**
**Seoul 07335 (KR)**

(72) Inventors:
• **PARK, Ji Hye**
  **Daejeon 34122 (KR)**
• **KIM, Hyeongseok**
  **Daejeon 34122 (KR)**
• **CHO, Hana**
  **Daejeon 34122 (KR)**

(74) Representative: **Plasseraud IP**
**104 Rue de Richelieu**
**CS92104**
**75080 Paris Cedex 02 (FR)**

(54) **METHOD FOR MEASURING RESISTANCE OF TARGET ELECTRODE AND ELECTRODE DEVICE FOR PERFORMING SAME**

(57)    Disclosed are a method and an electronic device for measuring the resistance of a target electrode, the method comprising the steps of: acquiring a chart related to the electrical conductivity of a target electrode according to changes in frequency after the target electrode has been immersed in an electrolyte for a predefined time or longer; determining a first point and a second point on the electrical conductivity graph of the target electrode, the graph being included in the chart; and measuring the resistance of the target electrode on the basis of the first point and the second point.

**FIG. 2**

## Description

### Technical Field

The present disclosure relates to a method and electronic device for measuring a resistance of a target electrode.

### Background Art

Electrical conductivity within an electrode is one of the factors affecting the battery performance, and accurate prediction of conductivity parameters of an electrode is an essential element required for enhancing the performance of a battery model. The most widely used method for measuring the electrical conductivity of a lithium secondary battery, which has high energy density and operating potential, a long cycle life, and a low self-discharge rate, is mainly a method of measuring the probe resistance or the vertical resistance of a dried electrode.

Since an actual battery operates while impregnated with an electrolyte solution, various research efforts are directed toward accurately measuring the electrical conductivity under actual driving conditions as well as when an electrode is dried, and obtaining the information needed for battery operation.

### Detailed Description of the Invention

### Technical Goals

It is a technical object of the present disclosure according to example embodiments to measure an electrical conductivity of an electrode according to a frequency change of a target electrode impregnated with an electrolyte solution using broadband dielectric spectroscopy (BDS), analyze a graph of the electrical conductivity of the electrode that varies according to the frequency change, and measure a resistance of the target electrode according to resistance values determined based on a predetermined area of the graph.

In addition, it is another technical object of the present disclosure according to example embodiments to determine at an early stage, through verifying an electrode with a predetermined specification before manufacturing a complete product, whether a manufactured battery is a normal electrode that falls within a range in which the battery may operate normally while impregnated with an actual electrolyte solution.

The goals to be achieved by example embodiments of the present disclosure are not limited to the objects described above and other objects may be inferred from the following example embodiments.

### Technical solutions

According to an aspect, there is provided a method for measuring a resistance of a target electrode, the method including acquiring a chart of an electrical conductivity of the target electrode according to a frequency change after the target electrode is impregnated with an electrolyte solution for a predetermined time or longer, determining a first point of an electrical conductivity graph of the target electrode included in the chart and a second point of the electrical conductivity graph, and measuring the resistance of the target electrode based on the first point and the second point.

The chart of the electrical conductivity of the target electrode may include a first axis for a real component of the electrical conductivity of the target electrode and a second axis for an imaginary component of the electrical conductivity of the target electrode, which is perpendicular to the first axis.

The determining may include determining an intersection point of the first axis for the real component of the electrical conductivity graph and the electrical conductivity graph to be the first point and determining an inflection point of the electrical conductivity graph according to a frequency increase to be the second point, and the measuring may include measuring a first resistance based on a reciprocal value of a first electrical conductivity at the first point of the electrical conductivity graph, and measuring a second resistance based on a difference between a reciprocal value of a second electrical conductivity at the second point and the reciprocal value of the first electrical conductivity at the first point of the electrical conductivity graph.

The resistance of the target electrode may be determined based on a sum of an electronic resistance of the target electrode and an ionic resistance of the target electrode, and the electronic resistance of the target electrode may be the first resistance and the ionic resistance of the target electrode may be the second resistance.

The method may further include acquiring a resistance of a reference battery cell, and verifying that the target electrode is a normal electrode when a difference between the resistance of the reference battery cell and the resistance of the target electrode is below a threshold value, and the reference battery cell may include at least one or more target electrodes and may be impregnated with the electrolyte solution for a predetermined time or longer.

The electrical conductivity of the target electrode according to the frequency change may be acquired using broad dielectric spectroscopy.

A process of impregnating the target electrode may be a process of impregnating the target electrode for a predetermined time or longer after injecting the electrolyte solution into the electrode holder while the target electrode is interposed inside the electrode holder, and the electrode holder may include a cylindrical upper plate, a cylindrical lower plate with a recess into which the upper plate is to be inserted, an inner wall of the recess of the lower plate may include polytetrafluoroethylene, and the target electrode may be interposed between the upper plate and the lower plate of the electrode holder.

The first resistance and the second resistance may be determined in inverse proportion to a conductive material content of an entire active material layer of the target electrode including an active material, a conductive material, and a binder.

According to another aspect, there is also provided an electronic device including a memory configured to store an instruction, and a processor connected to the memory, and the processor is configured to acquire a chart of an electrical conductivity of the target electrode according to a frequency change , after the target electrode is impregnated with an electrolyte solution for a predetermined time or longer, determine a first point of an electrical conductivity graph of the target electrode included in the chart and a second point of the electrical conductivity graph, and measure a resistance of the target electrode based on the first point and the second point.

Specific details of other embodiments are included in the detailed description and drawings.

**Effects of the Invention**

According to example embodiments proposed herein, one or more of the following effects may be expected.

According to example embodiments of the present disclosure, it is possible to measure an electrical conductivity of the electrode according to a frequency change of a target electrode impregnated with an electrolyte solution using broadband dielectric spectroscopy (BDS), analyze a graph of the electrical conductivity of the electrode that varies according to the frequency change, and measure a resistance of the target electrode according to resistance values determined based on a specific area of the graph.

In addition, according to example embodiments of the present disclosure, it is possible to reduce a resource required in detecting a defective electrode as it is possible to determine at an early stage, through verifying an electrode with a particular specification before manufacturing a complete product, whether a manufactured battery is a normal electrode that falls within a range in which the battery may operate normally while impregnated with an actual electrolyte solution.

Effects of the present disclosure are not limited to those described above and other effects may be made apparent to those skilled in the art from the following description.

**Brief Description of Drawings**

FIG. 1 is a diagram for describing a configuration of a target electrode resistance measuring system according to an example embodiment.
FIG. 2 is a flow chart for describing a method for measuring a resistance of a target electrode according to an example embodiment.
FIG. 3 is a diagram for describing a configuration of a device for implementing a method for measuring a resistance of a target electrode according to an example embodiment.
FIG. 4 is a diagram for describing a resistance of a target electrode according to an example embodiment.
FIG. 5 is a diagram for describing a chart of an electrical conductivity of a target electrode according to an example embodiment.
FIG. 6 is a block diagram of an electronic device according to an example embodiment.

**Mode for Carrying Out the Invention**

Terms used in the example embodiments are selected, as much as possible, from general terms that are widely used at present while taking into consideration the functions obtained in accordance with the present disclosure, but these terms may be replaced by other terms based on intentions of those skilled in the art, customs, emergence of new technologies, or the like. Also, in a particular case, terms that are arbitrarily selected by the applicant of the present disclosure may be used, and in this case the meanings of these terms may be described in detail in corresponding description parts of the disclosure. Accordingly, it should be noted that the terms used herein should be construed based on practical meanings thereof and the whole content of this specification, rather than being simply construed based on names of the terms.

In the entire specification, when an element is referred to as "comprising" or "including" another element, the element should not be understood as excluding other elements so long as there is no special conflicting description, and the element may include at least one another element.

Throughout the specification, expression "at least one of a, b, and c" may include 'a only', 'b only', 'c only', 'a and b', 'a and c', 'b and c', or 'all of a, b, and c'.

In the present disclosure, a "device" may be implemented as a computer, or a portable terminal capable of accessing a server or another terminal through a network. Here, the computer may include, for example, a laptop computer, a desktop computer, and a notebook equipped with a web browser. The portable terminal may be a wireless communication device ensuring a portability and a mobility, and include any type of handheld wireless communication device, for example, a communication-based terminal such as international mobile telecommunication (IMT), code division multiple access (CDMA), W-code division multiple access (W-CDMA), and long-term evolution (LTE), a smartphone, a tablet PC, and the like.

In the following description, example embodiments of the present disclosure will be described in detail with reference to the drawings so that those skilled in the art can easily carry out the present disclosure. The present disclosure may be embodied in many different forms and is not limited to the example embodiments described herein.

Hereinafter, example embodiments of the present disclosure will be described in detail with reference to the drawings.

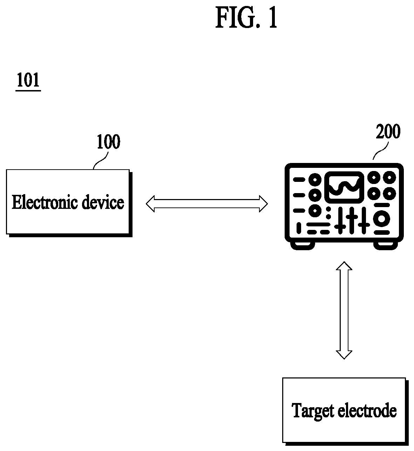

FIG. 1 is a diagram for describing a configuration of a target electrode resistance measuring system according to an example embodiment.

Referring to FIG. 1, a system 101 may include broadband dielectric spectroscopy (BDS) 200 for measuring an electrical conductivity of a target electrode and an electronic device 100 that receives information on the electrical conductivity of the target electrode through the BDS 200 and determines a resistance of a battery cell based thereon. In this case, the target electrode may be an electrode which is impregnated with an electrolyte solution for a predetermined time or longer. On the other hand, only components related to the example embodiment are illustrated in FIG. 1. Therefore, it may be understood by those skilled in the art that other general-purpose components may be further included in addition to the components illustrated in FIG. 1.

The electronic device 100 may each include one or more sensors for measuring a parameter of the target electrode including the above-described electrical conductivity of the target electrode subject to resistance measurement and may include a memory and a processor (not shown) for various operations. That is, after the BDS 200 applies an alternating current to the target electrode while changing a frequency and acquires a chart of the electrical conductivity of the target electrode, the electronic device 100 may receive information on the chart through the sensor and perform an operation of measuring a resistance of the target electrode. In this case, the chart of the electrical conductivity of the target electrode may correspond to a Nyquist plot chart. Here, the BDS 200 and the electronic device 100 may be independent objects that are completely separated from each other as illustrated in FIG. 1, but may also be conceptually separated only and exist within one device or one system. That is, one computing device capable of acquiring a chart of an electrical conductivity of a target electrode by applying, while changing a frequency, an alternating current to the target electrode and measuring a resistance of the target electrode based thereon may perform all functions of the electronic device 100 to be described below, and therefore, it is considered that such an example embodiment also falls within the scope of the present disclosure.

According to an example embodiment, the target electrode may include an active material, a binder, and a conductive material and may include a plurality of electrodes only different in a content of the conductive material. As an example, the target electrode may include a plurality of target electrodes having an identical type of the active material and an identical type of the binder and different in the content of the conductive material in an entire electrode slurry. As an example, the target electrode may be manufactured by preparing an active material slurry that includes the active material, the binder, and the conductive material, doping and drying the prepared active material slurry on a metal foil, and then performing a process of rolling thereof. The target electrode may be a positive electrode according to an example embodiment.

As an example, the target electrode may correspond to a target electrode of which the active material takes up 97 %, the binder takes up 2 %, and the conductive material takes up 1 % of a total mass of an active material layer including the active material, the binder, and the conductive material and in which a conductive material content of the entire active material layer of the target electrode is 1 %.

As another example, the target electrode may correspond to a target electrode of which the active material takes up 97%, the binder takes up 1 % and the conductive material takes up 2 % of the total mass of the active material layer including the active material, the binder, and the conductive material and in which the conductive material content of the entire active material layer of the target electrode is 2 %. However, example embodiments of the present disclosure are not limited to the above-describe cases in which the conductive material content of the entire active material layer of the target electrode is predetermined.

# EP 4 772 889 A1

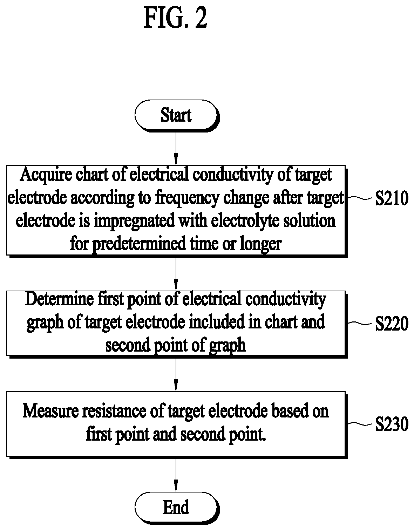

FIG. 2 is a flow chart for describing a method for measuring a resistance of a target electrode according to an example embodiment.

Referring to FIG. 2, the electronic device 100 according to an example embodiment may acquire a chart of an electrical conductivity of the target electrode according to a frequency change after the target electrode is impregnated with an electrolyte solution for a predetermined time or longer in operation S210. The target electrode may be a positive electrode impregnated with the electrolyte solution for the predetermined time (e.g., 30 minutes).

According to an example embodiment, data on the electrical conductivity of the target electrode may be acquired using broadband dielectric spectroscopy (BDS). The BDS may measure the electrical conductivity of the target electrode according to a frequency by applying an alternating current to the target electrode while changing the frequency. The electronic device 100 may acquire, from the BDS, the data on the electrical conductivity of the target electrode acquired by applying the alternating current while changing the frequency and may acquire the chart of the electrical conductivity of the target electrode according to the frequency change by analyzing the data. In this case, an operation of acquiring the chart of the electrical conductivity of the target electrode may include a process of observing a change in the electrical conductivity of the target electrode according to a change in the alternating current, and more specifically, may include a process of acquiring a chart of an electrical conductivity of an electrode corresponding to a frequency of the alternating current by measuring the electrical conductivity of the electrode while increasing the frequency of the alternating current at predetermined intervals. In this case, the chart of the electrical conductivity of the target electrode may correspond to a Nyquist plot chart. Here, the Nyquist plot chart may refer to a chart for evaluating stability of a system through a parameter plot of a frequency response used for automatic controlling and signal processing. The Nyquist plot chart may refer to a chart that visualizes a graph showing a response according to a frequency change of a system on a complex plane including an axis for a real component and an axis for an imaginary component. The Nyquist plot chart of the electrical conductivity of the target electrode according to an example embodiment may refer to a chart that visualizes a graph illustrating the electrical conductivity of the target electrode according to the frequency change of the alternating current applied to the target electrode on a complex plane including an axis for a real component and an axis for an imaginary component.

According to another example embodiment, the electronic device 100 may measure the electrical conductivity of the target electrode according to the frequency by applying the alternating current to the target electrode by changing the frequency and acquire the chart of the electrical conductivity of the target electrode according to the frequency using the data measured.

The electronic device 100 according to an example embodiment may determine a first point and a second point of the graph in operation S220. The electronic device 100 according to an example embodiment may determine an intersection point of a first axis for a real component of an electrical conductivity graph and the electrical conductivity graph to be the first point. The electronic device 100 according to an example embodiment may determine an inflection point of the electrical conductivity graph according to a frequency increase to be the second point. As an example, the electronic device 100 may determine a point on the electrical conductivity graph when the frequency is 100 hertz (hz) to be the first point and determine a point on the electrical conductivity graph when the frequency is $10^6$ hz to be the second point. However, the first point and the second point according to example embodiments of the present disclosure are not limited to be points of the electrical conductivity graph at specific frequencies.

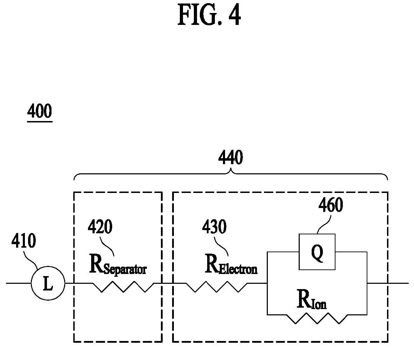

The electronic device 100 according to an example embodiment may measure the resistance of the target electrode based on the first point and the second point in operation S230. In this case, when the chart of the target electrode according to the frequency change is analyzed, the resistance of the target electrode may correspond to an ohmic resistance which is a resistance when an impedance includes only a real value. The resistance of the target electrode may correspond to a resistance obtained by adding all resistance components presented in an electrolyte, a current collector, a separator, or the like of the target electrode together and may be measured based on a characteristic of an ionic conductivity of the electrolyte. A circuit including a resistance component of the target electrode will be described in detail with reference to FIG. 4 below.

The electronic device 100 according to an example embodiment may further perform an operation of acquiring a resistance of a reference battery cell and verifying that the target electrode is a normal electrode when a difference between the resistance of the reference battery cell and the resistance of the target electrode is below a threshold value. In this case, the reference battery cell may include at least more than one (e.g., two) target electrodes and may be impregnated with the electrolyte solution for a predetermined time or longer.

As an example, the reference battery cell may be a battery cell in which two positive target electrodes are manufactured to be in contact with each other and impregnated with the electrolyte solution for a predetermined time or longer. The electronic device 100 according to an example embodiment may acquire the resistance through an impedance analysis of the reference battery cell with 1 % of conductive material content and verify that the target electrode is the normal electrode when the difference between the resistance of the reference battery cell with 1 % conductive material content and the resistance of the target electrode with 1 % conductive material content is below the threshold value. Here, the reference battery cell with 1 % conductive material content may refer to a battery cell of which a conductive material content of an entire active material layer of the target electrode is 1 % by mass. The entire active material layer may indicate an active material, a conductive material, and a binder. As an example, when the resistance of the target electrode with 1 % conductive material content according to the method for measuring the resistance of the target electrode according to an example embodiment is approximately 0.22 ohms ($\Omega$), and when the resistance of the reference battery cell with 1 % of the conductive material content is approximately 0.23 $\Omega$, the electronic device 100 may determine that the difference between the resistance of the reference battery cell with 1 % conductive material content and the resistance of the target electrode with 1 % conductive material content is below the threshold value and verify that the target electrode is the normal electrode that is not greatly different from the resistance of the reference battery cell. As an example, the electronic device 100 may acquire the resistance through the impedance analysis of the reference battery cell with 2 % conductive material content and verify that the target electrode is the normal electrode when the difference between the resistance of the reference battery cell with 2 % conductive material content and the resistance of the target electrode with 2 % conductive material content is below the threshold value. Here, the reference battery cell with 2 % conductive material content may refer to a battery cell of which the conductive material content of the entire active material layer of the target electrode is 2 % by mass. As an example, when the resistance of the target electrode with 2 % of conductive material content according to an example embodiment of the method for measuring the resistance of the target electrode is approximately 0.063 $\Omega$, and when the resistance of the reference battery cell with 2 % of the conductive material content is approximately 0.064 $\Omega$, the electronic device 100 may determine that the difference between the resistance of the reference battery cell with 2 % conductive material content and the resistance of the target electrode with 2 % conductive material content is below the threshold value and verify that the target electrode is the normal electrode that is not greatly different from the resistance of the reference battery cell.

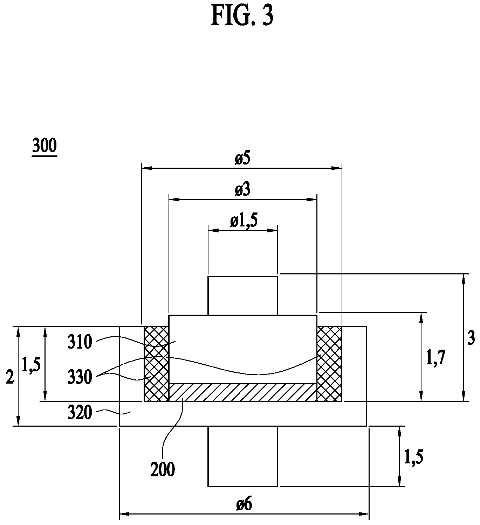

FIG. 3 is a diagram for describing a configuration of an electrode holder for implementing a method for measuring a resistance of a target electrode according to an example embodiment.

Referring to FIG. 3, the configuration of the electrode holder for implementing the method for measuring the resistance of the target electrode may be identified. The method for measuring the resistance of the target electrode according to an example embodiment may include a process of measuring an electrical conductivity of the target electrode using a BDS as described above, and FIG. 3 illustrates a structure of the electrode holder for analyzing the electrical conductivity of the target electrode impregnated with an electrolyte solution for a predetermined time or longer through the BDS.

An electrode holder 300 used in the method for measuring the resistance of the target electrode according to an example embodiment may include a cylindrical upper plate 310 and a cylindrical lower plate 320 with a recess into which the upper plate 310 may be inserted, an inner wall 330 of the recess of the lower plate 320 may include polytetrafluoroethylene (PTFE), and the target electrode may be interposed between the upper plate 310 and the lower plate 320 of the electrode holder. That is, the BDS may acquire information on the electrical conductivity of the target electrode by applying an alternating current while changing a frequency to the target electrode positioned between the upper plate 310 and the lower plate 320 of the electrode holder 300. As an example, both of the upper plate 310 and the lower plate 320 may include a plating (vergoldet) material, and the inner wall 330 of the recess of the lower plate 320 may be filled with a PTFE material and configured to prevent direct contact between the upper plate 310 and the lower plate 320. An inner diameter and a height of each of the upper plate 310 and the lower plate 320 may have lengths identical to those illustrated in FIG. 3 and may be configured so that an electrode to measure falls within a specification supported by the BDS. According to an example embodiment, a process of analyzing the electrical conductivity of the target electrode may include a process of analyzing the electrical conductivity of the target electrode through the BDS after placing the target electrode inside the electrode holder 300 and injecting the electrolyte solution, covering an upper part of the electrode holder 300, and impregnating the target electrode for a predetermined time or longer (e.g., 30 minutes). Through this, a noise occurring due to insufficient permeation of the electrolyte solution into the target electrode when the target electrode is impregnated for less than the predetermined time may be prevented.

FIG. 4 is a diagram for describing a resistance of a target electrode according to an example embodiment.

Referring to FIG. 4, a circuit 400 including a resistance component 440 of the target electrode according to an example embodiment may be identified. The circuit 400 may include an inductance component 410, a separator resistance component 420, an electronic resistance component 430, an ionic resistance component, and a constant phase element of solid electrolyte interphase (CPESEI) component 460 of the target electrode. In this case, the inductance component 410 of the target electrode may correspond to a parasitic impedance component, and the CPESEI component 460 may correspond to an impedance component caused by an electrical property of an electrical double-layer occurring, due to a high conductivity of a plating material included in the upper plate 310 and the lower plate 320 of the electrode holder 300 as described with reference to FIG. 3, between a foil of the target electrode and each of the upper plate 310 and the lower plate 320. That is, the CPESEI component 460 may correspond to a resistance component caused by an electrolyte solution impregnated between the target electrode and each of the upper plate 310 and the lower plate 320. An illustration in FIG. 4 is merely an example, and a shape of the circuit 400 including a resistance 430 of the target electrode according to an example embodiment of the present disclosure is not limited thereto.

In this case, the separator resistance component 420 may correspond to a resistance component occurring due to a separator formed between a positive electrode and a negative electrode and may correspond to a component that may be measured according to a thickness and a structure of the separator, and mobility of an ion. Since the positive electrode and the negative electrode of the target electrode may correspond to the positive electrode itself that does not include a structure separated by the separator, the separator resistance component 420 may correspond to a value close to 0, but the example embodiment of the present disclosure is not limited thereto.

The resistance component 440 of the target electrode according to an example embodiment may be a resistance component related to an electrical conductivity of the target electrode. The resistance of the target electrode measured according to the resistance component 440 of the target electrode according to an example embodiment may be measured based on a sum of a resistance of the electronic resistance component 430 of the target electrode and a resistance of the ionic resistance component 450 of the target electrode. In another example embodiment, the resistance of the target electrode may be measured based on a sum of resistances of the separator resistance components 420 of the target electrode. The resistance of the target electrode measured according to the resistance component 440 of the target electrode may be measured based on a sum of the resistance of the electronic resistance component 430 of the target electrode, the resistance of the ionic resistance component 450 of the target electrode, and the resistance of the separator resistance component 420, but a case in which the resistance of the separator resistance component 420 is significantly low as being close to 0 will be described as a reference below. However, the example embodiment of the present disclosure is not limited thereto.

The electronic resistance component 430 of the target electrode according to an example embodiment may be a resistance component related to a movement of an electron within the target electrode. The electronic resistance component 430 of the target electrode according to an example embodiment may be measured based on a ratio of a conductive material of the target electrode and a surface structure of the target electrode.

The ionic resistance component 450 of the target electrode according to an example embodiment may refer to a resistance component related to a movement of an ion of the electrical double-layer occurring, due to the high conductivity of the plating material included in the upper plate 310 and the lower plate 320 of the electrode holder 300 as described with reference to FIG. 3, between the foil of the target electrode and each of the upper plate 310 and the lower plate 320 . The ionic resistance component 450 of the target electrode according to an example embodiment may be measured based on a concentration and a temperature of the electrolyte solution.

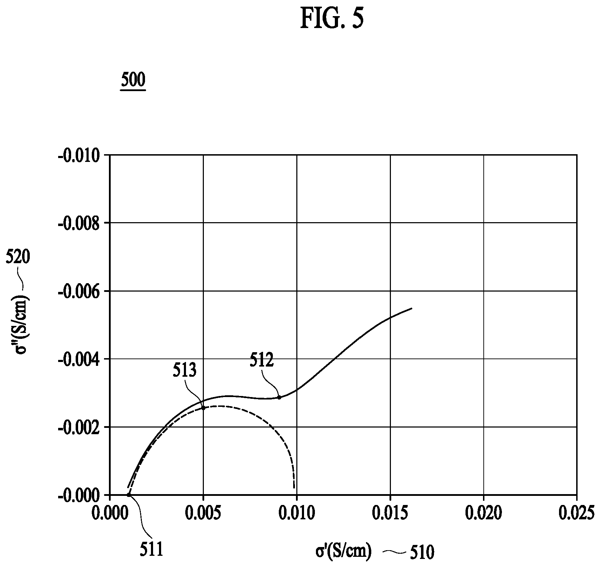

FIG. 5 is a diagram for describing a chart related to an electrical conductivity of a target electrode according to an example embodiment.

Referring to FIG. 5, the chart related to the electrical conductivity of the target electrode according to an example embodiment may be identified. A chart 500 according to an example embodiment may include a first axis 510 for a real component of the electrical conductivity of the target electrode and a second axis 520 for an imaginary component of the electric conductivity of the target electrode, which is perpendicular to the first axis 510. In other words, the chart 500 according to an example embodiment may include the first axis 510 for the real component of the electrical conductivity corresponding to a reciprocal of an impedance value of the target electrode at a predetermined frequency and the second axis 520 for the imaginary component of the electrical conductivity corresponding to the reciprocal of the impedance value of the target electrode at the predetermined frequency.

The electronic device 100 according to an example embodiment may determine a point corresponding to the electrical conductivity on the first axis 510 for the real component of a graph to be a first point 511 and may determine an inflection point according to a frequency increase to be a second point 512. The electronic device 100 according to an example embodiment may measure a first resistance based on a first electrical conductivity at the first point 511 of the graph. More specifically, the electronic device 100 according to an example embodiment may measure the first resistance, which is an electronic resistance of the target electrode, based on a reciprocal value of the first electrical conductivity at the first point 511. In other words, the electronic device 100 according to an example embodiment may acquire a second resistance based on an equation below.

[Equation 1]

$$Real\left(\frac{1}{\sigma_1}\right) = R_1$$

In this case, $\sigma_1$ may correspond to the first electrical conductivity at the first point 511, and $R_1$ may correspond to the first resistance. In this case, the first resistance may be determined in inverse proportion to a conductive material content of an entire active material layer of the target electrode including an active material, a conductive material, and a binder. In other words, since the electrical conductivity increases as the conductive material content of the entire active material layer of the target electrode increases, the first resistance may be inversely proportional to the conductive material content of the entire active material layer of the target electrode.

The electronic device 100 according to an example embodiment may determine a third point 513 at which a value of the second axis 520 for the imaginary component of the electrical conductivity of the target electrode is the largest while the graph moves from the first point 511 to the second point 512 according to the frequency increase and, when a component of the first axis 510 for the real component of the electrical conductivity of the target electrode at the third point 513 corresponds to an average of a component of the first axis 510 for the real component of the electrical conductivity of the target electrode at the first point 511 and a component of the first axis 510 for the real component of the electrical conductivity of the target electrode at the second point 512, acquire, for example, a second electrical conductivity that satisfies Equation 2 below.

[Equation 2]

$$Real\ (2(\sigma_3 - \sigma_1)) = \ Real\ (\sigma_2)$$

In this case, $\sigma_3$ may denote a third electrical conductivity at the third point 513 at which the value of the second axis 520 for the imaginary component of the electrical conductivity of the target electrode is the largest while the graph is moving from the first point 511 to the second point 512, $\sigma_1$ may denote the first electrical conductivity at the first point, and $\sigma_2$ may denote the second electrical conductivity. In other words, the electronic device 100 according to an example embodiment may determine a value, which corresponds to a diameter of a semicircle shown in the graph of the electrical conductivity of the target electrode while the graph is moving from the first point 511 to the second point 512 according to a frequency increase, to be the second electrical conductivity and may measure the second resistance based on a reciprocal value of a difference between the second electrical conductivity and the first electrical conductivity at the first point. As an example, the electronic device 100 according to an example embodiment may acquire the second resistance which is an ionic resistance of the target electrode based on the following Equation 3.

[Equation 3]

$$Real\ \left(\frac{1}{\sigma_2 - \sigma_1}\right) = \ R_2$$

In this case, $\sigma_1$ may denote the first electrical conductivity at the first point, $\sigma_2$ may denote the second electrical conductivity, and $R_2$ may denote the second resistance. In conclusion, the electronic device 100 according to an example embodiment may acquire information on the electrical conductivity of the target electrode impregnated with an electrolyte solution for a predetermined time or longer through BDS, acquire the chart 500 of the electrical conductivity of the target electrode, and measure a resistance of the target electrode by analyzing a specific point on an electrical conductivity graph included in the chart and measuring the electronic resistance component and the ionic resistance component forming an ohmic resistance of the target electrode.

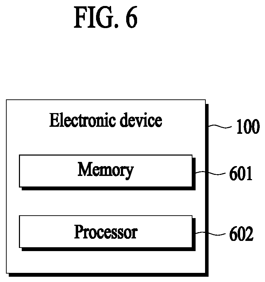

FIG. 6 is a block diagram of a server according to an example embodiment.

The electronic device 100 according to an example embodiment may include a memory 601 and a processor 602. In FIG. 6, only components related to the example embodiment are shown for the electronic device 100. Therefore, it may be understood by those skilled in the art that other general-purpose components may be further included in addition to the components illustrated in FIG. 6. The processor 602 according to an example embodiment may be included in a controller.

The processor 602 may control overall operations of the electronic device 100 and may process data and a signal. The processor 602 may be configured as at least one hardware unit. In addition, the processor 602 may be operated by at least one or more software modules that is created by executing a program code stored in the memory 601. As the processor 602 may include a memory, the processor 602 may control the overall operations of the electronic device 100 by executing a program code stored in the memory 601 and process the data and the signal.

The processor 602 may be configured to acquire a chart of an electrical conductivity of a target electrode according to a frequency change after the target electrode is impregnated with an electrolyte solution for a predetermined time or longer, determine a first point of an electrical conductivity graph of the target electrode and a second point of the electrical conductivity graph, and measure a resistance of the target electrode based on the first point and the second point.

According to example embodiments, the electronic device 100 may further include a transceiver for wired/wireless communication. The electronic device 100 may communicate with an external electronic device (e.g., the electronic device 100). The external electronic device may be a terminal or a server. In addition, the transceiver may use communication technologies such as a global system for mobile communication (GSM), a code division multi access (CDMA), a long-term evolution (LTE), a 5G, a wireless local area network (WLAN), a wireless-fidelity (Wi-Fi), a Bluetooth™, a radio frequency identification (RFID), an infrared data association (IrDA), a ZigBee, and a near field communication (NFC).

The server in accordance with the example embodiments described above may include a processor, a memory which stores and executes program data, a permanent storage such as a disk drive, a communication port for communication with an external device, and a user interface device such as a touch panel, a key, and a button. Methods realized by software modules or algorithms may be stored in a computer-readable recording medium as computer-readable codes or program commands which may be executed by the processor. Here, the computer-readable recording medium may be a magnetic storage medium (for example, a read-only memory (ROM), a random-access memory (RAM), a floppy disk, or a hard disk) or an optical reading medium (for example, a CD-ROM or a digital versatile disc (DVD)). The computer-readable recording medium may be dispersed to computer systems connected by a network so that computer-readable codes may be stored and executed in a dispersion manner. The medium may be read by a computer, may be stored in a memory, and may be executed by the processor.

The example embodiments may be represented by functional blocks and various processing steps. These functional blocks may be implemented by various numbers of hardware and/or software configurations that execute specific functions. For example, the example embodiments may adopt direct circuit configurations such as a memory, a processor, a logic circuit, and a look-up table that may execute various functions by control of one or more microprocessors or other control devices. Similarly to that elements may be executed by software programming or software elements, the example embodiments may be implemented by programming or scripting languages such as C, C++, Java, and assembler including various algorithms implemented by combinations of data structures, processes, routines, or of other programming configurations. Functional aspects may be implemented by algorithms executed by one or more processors. In addition, the example embodiments may adopt the related art for electronic environment setting, signal processing, and/or data processing, for example. The terms "mechanism", "element", "means", and "configuration" may be widely used and are not limited to mechanical and physical components. These terms may include meaning of a series of routines of software in association with a processor, for example.

The example embodiments described above are merely examples and other embodiments may be implemented within the scope of the following claims.

**Claims**

1.   A method for measuring a resistance of a target electrode, the method comprising:

acquiring a chart of an electrical conductivity of the target electrode according to a frequency change after the target electrode is impregnated with an electrolyte solution for a predetermined time or longer;
determining a first point of an electrical conductivity graph of the target electrode included in the chart and a second point of the electrical conductivity graph; and
measuring the resistance of the target electrode based on the first point and the second point.

2.   The method of claim 1, wherein the chart of the electrical conductivity of the target electrode comprises:

a first axis for a real component of the electrical conductivity of the target electrode; and
a second axis for an imaginary component of the electrical conductivity of the target electrode, which is perpendicular to the first axis.

3.   The method of claim 2, wherein the determining comprises determining

an intersection point of the first axis for the real component of the electrical conductivity graph and the electrical conductivity graph to be the first point and determining an inflection point of the electrical conductivity graph according to a frequency increase to be the second point, and
the measuring comprises:

measuring a first resistance based on a reciprocal value of a first electrical conductivity at the first point of the electrical conductivity graph; and
measuring a second resistance based on a difference between a reciprocal value of a second electrical conductivity at the second point and the reciprocal value of the first electrical conductivity at the first point of the electrical conductivity graph.

4.   The method of claim 3, wherein the resistance of the target electrode is

determined based on a sum of an electronic resistance of the target electrode and an ionic resistance of the target electrode, and
the electronic resistance of the target electrode is the first resistance and the ionic resistance of the target electrode is the second resistance.

5. The method of claim 1, further comprising:

acquiring a resistance of a reference battery cell; and
verifying that the target electrode is a normal electrode when a difference between the resistance of the reference battery cell and the resistance of the target electrode is below a threshold value, and
the reference battery cell includes at least one or more target electrodes and is impregnated with the electrolyte solution for a predetermined time or longer.

6. The method of claim 1, wherein the electrical conductivity of the target electrode according to the frequency change is acquired using broadband dielectric spectroscopy.

7. The method of claim 1, wherein a process of impregnating the target electrode is a process of impregnating the target electrode for a predetermined time or longer after injecting the electrolyte solution into an electrode holder in a state in which the target electrode is interposed inside the electrode holder,
wherein the electrode holder includes:

a cylindrical upper plate; and
a cylindrical lower plate with a recess into which the cylindrical upper plate is to be inserted,
wherein an inner wall of the recess of the cylindrical lower plate includes polytetrafluoroethylene, and
wherein the target electrode is interposed between the cylindrical upper plate and the cylindrical lower plate of the electrode holder.

8. The method of claim 3, wherein the first resistance and the second resistance are determined in reverse proportion to a conductive material content of an entire active material layer of the target electrode including an active material, a conductive material, and a binder.

9. A non-transitory computer-readable recording medium in which a program for executing the method of any one of claims 1 through 8 on a server is recorded.

10. An electronic device comprising:

a memory configured to store an instruction; and
a processor connected to the memory,
wherein the processor is configured to:

acquire a chart of an electrical conductivity of a target electrode according to a frequency change after the target electrode is impregnated with an electrolyte solution for a predetermined time or longer;
determine a first point of an electrical conductivity graph of the target electrode included in the chart and a second point of the electrical conductivity graph; and
measure a resistance of the target electrode based on the first point and the second point.

# FIG. 1

101

100

Electronic device

200

Target electrode

# FIG. 2

Start

Acquire chart of electrical conductivity of target electrode according to frequency change after target electrode is impregnated with electrolyte solution for predetermined time or longer — S210

Determine first point of electrical conductivity graph of target electrode included in chart and second point of graph — S220

Measure resistance of target electrode based on first point and second point. — S230

End

# FIG. 3

# FIG. 4

<u>400</u>

# FIG. 5

## FIG. 6

Electronic device — 100

Memory — 601

Processor — 602

## INTERNATIONAL SEARCH REPORT

| International application No. |
|---|
| **PCT/KR2024/017059** |

| **A. CLASSIFICATION OF SUBJECT MATTER** |
|---|
| **G01R 27/02**(2006.01)i; **G01R 19/165**(2006.01)i; **G01R 19/02**(2006.01)i; **G01R 23/16**(2006.01)i; **G01N 27/02**(2006.01)i; **H01M 10/42**(2006.01)i |
| According to International Patent Classification (IPC) or to both national classification and IPC |

| **B. FIELDS SEARCHED** |
|---|
| Minimum documentation searched (classification system followed by classification symbols) |
| G01R 27/02(2006.01); G01N 27/02(2006.01); G01N 27/04(2006.01); G01R 1/04(2006.01); H01M 10/052(2010.01); H01M 10/48(2006.01); H01M 4/139(2010.01); H01M 4/505(2010.01); H01M 4/525(2010.01) |
| Documentation searched other than minimum documentation to the extent that such documents are included in the fields searched |
| Korean utility models and applications for utility models: IPC as above<br>Japanese utility models and applications for utility models: IPC as above |
| Electronic data base consulted during the international search (name of data base and, where practicable, search terms used) |
| eKOMPASS (KIPO internal) & keywords: 전극(electrode), 저항(resistance), 측정(measure), 함침(impregnation), 주파수 (frequency) |

| **C. DOCUMENTS CONSIDERED TO BE RELEVANT** | | |
|---|---|---|
| Category* | Citation of document, with indication, where appropriate, of the relevant passages | Relevant to claim No. |
| Y<br><br>A | KR 10-2019-0053014 A (LG CHEM, LTD.) 17 May 2019 (2019-05-17)<br>See paragraphs [0072]-[0076], claim 1 and figure 1. | 1-2,5-6,9-10<br><br>3-4,7-8 |
| Y | JP 2015-043335 A (SUMITOMO METAL MINING CO., LTD.) 05 March 2015 (2015-03-05)<br>See paragraph [0150] and figure 6. | 1-2,5-6,9-10 |
| Y | KR 10-2024-0045914 A (LG ENERGY SOLUTION, LTD.) 08 April 2024 (2024-04-08)<br>See claim 1. | 5 |
| Y | KR 10-2019-0032096 A (LG CHEM, LTD.) 27 March 2019 (2019-03-27)<br>See claim 1. | 6 |
| A | CN 214953777 U (SHANGHAI CENAT NEW ENERGY CO., LTD.) 30 November 2021 (2021-11-30)<br>See paragraphs [0024]-[0049] and figure 1. | 1-10 |

| ☐ Further documents are listed in the continuation of Box C. | ☑ See patent family annex. |
|---|---|

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **11 February 2025** | **11 February 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/017059**

| Patent document cited in search report | | | Publication date (day/month/year) | Patent family member(s) | | | Publication date (day/month/year) |
|---|---|---|---|---|---|---|---|
| KR | 10-2019-0053014 | A | 17 May 2019 | CN | 110537093 | A | 03 December 2019 |
| | | | | CN | 110537093 | B | 08 March 2022 |
| | | | | EP | 3657160 | A1 | 27 May 2020 |
| | | | | EP | 3657160 | B1 | 03 March 2021 |
| | | | | JP | 2020-517953 | A | 18 June 2020 |
| | | | | JP | 6777827 | B2 | 28 October 2020 |
| | | | | US | 11264599 | B2 | 01 March 2022 |
| | | | | US | 2020-0185697 | A1 | 11 June 2020 |
| | | | | WO | 2019-093687 | A1 | 16 May 2019 |
| JP | 2015-043335 | A | 05 March 2015 | JP | 5811383 | B2 | 11 November 2015 |
| KR | 10-2024-0045914 | A | 08 April 2024 | WO | 2024-071814 | A1 | 04 April 2024 |
| KR | 10-2019-0032096 | A | 27 March 2019 | CN | 110998921 | A | 10 April 2020 |
| | | | | CN | 110998921 | B | 11 April 2023 |
| | | | | EP | 3686967 | A2 | 29 July 2020 |
| | | | | JP | 2020-535593 | A | 03 December 2020 |
| | | | | JP | 2022-125286 | A | 26 August 2022 |
| | | | | JP | 7442915 | B2 | 05 March 2024 |
| | | | | US | 11710817 | B2 | 25 July 2023 |
| | | | | US | 2021-0036307 | A1 | 04 February 2021 |
| | | | | WO | 2019-059619 | A2 | 28 March 2019 |
| | | | | WO | 2019-059619 | A3 | 09 May 2019 |
| CN | 214953777 | U | 30 November 2021 | None | | | |

Form PCT/ISA/210 (patent family annex) (July 2022)